# EUROPEAN PATENT SPECIFICATION

(11) **EP 1 662 653 B1**
(45) Date of publication and mention of the grant of the patent: **11.03.2009**
(21) Application number: 05003498.2
(22) Date of filing: 18.02.2005
(51) Int. Cl.: H03D 3/00

(54) **Demodulator of frequency modulated signals**
FM-Demodulator und Verfahren dazu
Démodulateur-FM et procédé

(30) Priority: 22.11.2004 JP 2004337062
(43) Date of publication of application: 31.05.2006
(73) Proprietor: Fujitsu Microelectronics Limited, Tokyo 163-0722 (JP)
(72) Inventor: Ogawa, Kazumi, Kasugai-shi Aichi 487-0012 (JP); Kato, Susumu, Kasugai-shi Aichi 487-0012 (JP); Kinoshita, Hidefumi, Kasugai-shi Aichi 487-0012 (JP); Oki, Hideta, Kasugai-shi Aichi 487-0012 (JP)
(74) Representative: Seeger, Wolfgang

(56) References cited:
- WO-A-01/19047
- US-A- 4 766 392
- US-A- 4 893 316
- US-A1- 2004 207 464

## Description

### CROSS-REFERENCE TO RELATED APPLICATIONS

This application is based upon and claims the benefit of priority from each of the prior Japanese Patent Application No. 2004-337062 filed on November 22, 2004.

### BACKGROUND OF THE INVENTION

### 1. Field of the Invention

The present invention relates to demodulation of frequency modulated signals, and more particularly to demodulation of modulated signals small in frequency deviation.

### 2. Description of Related Art

A demodulator according to the upper clause of claim 1 is disclosed in US-A-4 766 392.

In an FM detector disclosed in Japanese unexamined patent publication No. 2002-299960, as shown in Fig. 8, an inputted FM signal is multiplied by N times in an N times multiplying circuit 600, and the carrier frequency and modulation index are multiplied by N times. The signal multiplied by N times is branched, and one signal is shifted in phase in a phase shifting circuit 200, and put into a mixer 300, and other signal is directly put into the mixer 300. In the mixer 300, two signals equal in frequency and different in phase are processed by multiplication. The phase shifting circuit 200 is set to shift the phase by odd-number times at 90 degrees with respect to the center frequency of the input signal, and when a frequency modulated signal is inputted in the phase shifting circuit 200, the phase shifting amount varies depending on the input signal frequency. The output of the mixer 300 has a component proportional to this phase shift variation amount, and by passing the mixer output through a low pass filter 400, a base band output is obtained. The amplitude of the base band output is a signal proportional to the shaft shifting amount and the modulation index corresponding to the carrier signal. By multiplying by N times, a base band output having output amplitude of N times can be obtained.

Further, a method is known to demodulate an input signal including frequency deviation by way of a quadrature converter such as IQ-MIX circuit. By adjusting the frequency of local signal inputted in the IQ-MIX circuit to the carrier frequency of input signal, two signals having frequency of frequency deviation and mutual phase difference of 90 degrees are outputted as I output and Q output. It is intended to demodulate depending on the phase difference of I output and Q output.

### SUMMARY OF THE INVENTION

In the above publication '960, by multiplying the input signal by N times, indeed, the modulation index is multiplied by N times, and the voltage amplitude of the base band output is multiplied by N times.

However, when outputting the frequency variation of input signal depending on the modulation index as voltage amplitude of base band output, it is multiplied by N times and the sensitivity of the base band output is enhanced, but since the base band output is a voltage signal, the amplitude value may be varied by noise. If the resistance to noise is low, the sensitivity enhancing effect by N times multiplication may be decreased or canceled.

In the method of making use of quadrature converter, it is intended to demodulate depending on the phase shifting direction of I output and Q output having a mutual phase difference of 90 degrees, but in the recent trend of effective use of radio waves, the frequency deviation tends to be narrowed, and the oscillation frequency in the I output and Q output outputted from the quadrature converter is forced to be low frequency depending on the frequency deviation. Accordingly, the period of demodulation based on the I output and Q output of low frequency is forced to be long period, and the deviation width of demodulation timing fluctuates at maximum of period of frequency deviation, from the transmission signal shifting nonsynchronously with the frequency deviation, and jitter occurs in the demodulated signal. In the narrowing trend of frequency deviation, jitter of demodulated signal increases and becomes a serious problem.

The invention is devised to solve at least one of the problems of the related art, and it is hence an object thereof to present a demodulator of frequency modulated signals and a demodulating method of frequency modulated signals, capable of demodulating favorably frequency modulated signals having frequency deviation.

This object is achieved by the features of claim 1.

In the demodulator of frequency modulated signals of the invention, the signal converting unit converts the input signal having a frequency deviation from the carrier frequency into an input square signal, and the demodulation unit converts the input square signal by quadrature and demodulates, depending on the first signal of frequency coinciding with N-degree higher harmonic wave (N being 2 or greater natural number) of the carrier frequency issued from the signal output unit.

The demodulating method of frequency modulated signals of the invention has been achieved by the features of claim 9.

In the demodulating method of frequency modulated signals of the invention, the input signal having a frequency deviation from the carrier frequency is converted into an input square signal of same frequency, and the input square signal is converted by quadrature and demodulated, depending on the first signal of frequency coinciding with N-degree higher harmonic wave (N being 2 or greater natural number) of the carrier frequency.

Accordingly, the N-degree higher harmonic wave can be taken out from the input square signal of same frequency as input signal, and be demodulated by quadrature conversion, and two inverting signals can be obtained depending on the direction of the frequency deviation of mutual phase difference of 90 degrees, at frequency of N times of the frequency of frequency deviation. By quadrature conversion for obtaining demodulated signal by logic operation, the characteristic excellent in resistance to noise is shown, and by demodulation at N times frequency to frequency of frequency deviation, the demodulation timing for detecting the transmission signal is a narrow time interval, and deviation width of transition timing of transmission signal and demodulation timing can be suppressed. Hence, jitter of demodulated signal can be suppressed.

By demodulating N times frequency of frequency deviation by using N-degree higher harmonic wave, a demodulated signal of suppressed jitter can be obtained even if the frequency deviation is being narrowed in the trend of effective use of frequency band.

The above and further objects and novel features of the invention will morefully appear from the following detailed description when the same is read in connection with the acc ompanying drawings. It is to be expressly understood, howev er, that the drawings are for the purpose of illustration on ly and are not intended as a definition of the limits of the invention.

### BRIEF DESCRIPTION OF THE DRAWINGS

Fig. 1 is a diagram explaining the principle of the invention;
Fig. 2 is a circuit block diagram of a first embodiment;
Fig. 3 is a circuit block diagram showing a specific example of demodulating unit in the first embodiment;
Fig. 4 is a waveform diagram showing operation of the demodulating unit in Fig. 3;
Fig. 5 is a circuit block diagram showing a first modified example of the first embodiment;
Fig. 6 is a circuit block diagram showing a second modified example of the first embodiment;
Fig. 7 is an application example of the first embodiment; and

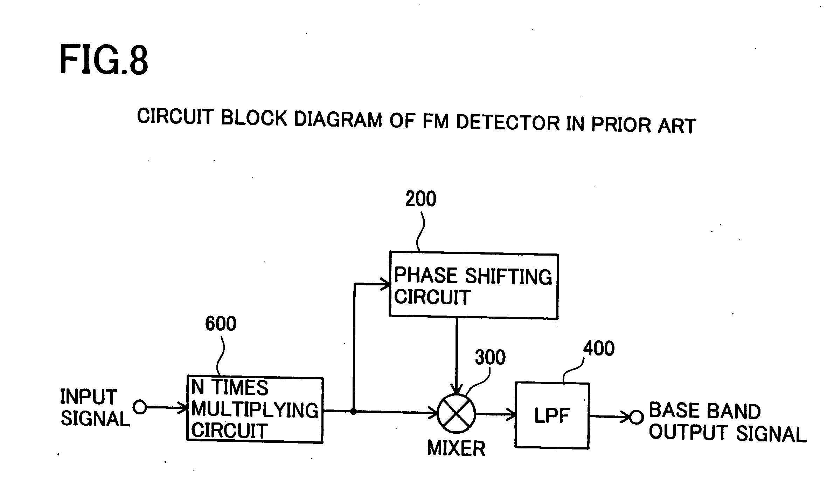

Fig. 8 is a circuit block diagram of FM detector disclosed in Japanese unexamined patent publication No. 2002-299960.

### DETAILED DESCRIPTION OF THE PREFERRED EMBODIMENTS

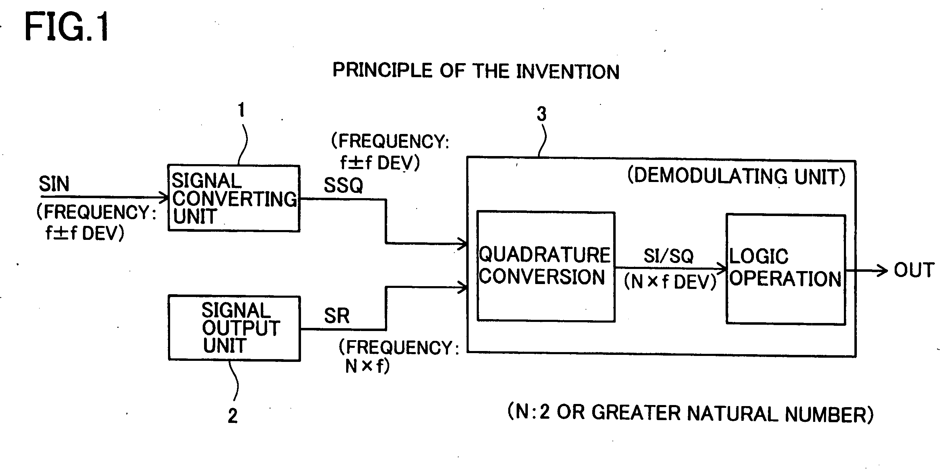

The demodulator and demodulating method of frequency modulated signals of the invention are described specifically below while referring to Fig. 1 to Fig. 7 showing the preferred embodiment thereof.

Fig. 1 is a diagram explaining the principle of demodulator and demodulating method of frequency modulated signals of the invention. When an input signal SIN (frequency: f±fDEV) modulated in frequency from frequency deviation (frequency: ±fDEV) with respect to carrier frequency signal (frequency: f) is inputted in a signal converting unit 1, an input square signal SSQ (frequency: f±fDEV) of same frequency as input signal SIN is outputted. Herein, the frequency (f±fDEV) of input square signal SSQ is fundamental frequency of input square signal SSQ. The input square signal SSQ is a signal containing fundamental frequency and harmonic component based on odd-number times of fundamental frequency. On the other hand, a signal output unit 2 outputs a first signal SR (frequency: N x f) having frequency of N times (N being 2 or greater natural number) of carrier frequency signal (frequency: f).

Input square signal SSQ and a first signal SR are inputted in a demodulating unit 3. The input square signal SSQ is a square signal, containing a fundamental frequency (f) and an N-degree harmonic component. Hence, when the input square signal SSQ is converted by quadrature depending on the first signal SR (frequency: N x f), two signals SI and SQ inverted in phase difference by 90 degrees are obtained, which are signals having N times of frequency (N x fDEV) of frequency deviation, with the frequency deviation from the carrier frequency signal according to the frequency modulation, depending on the direction of deviation, whether frequency: +fDEV or frequency: -fDEV. These two signals SI and SQ inverted in phase difference by 90 degrees are logically operated and demodulated.

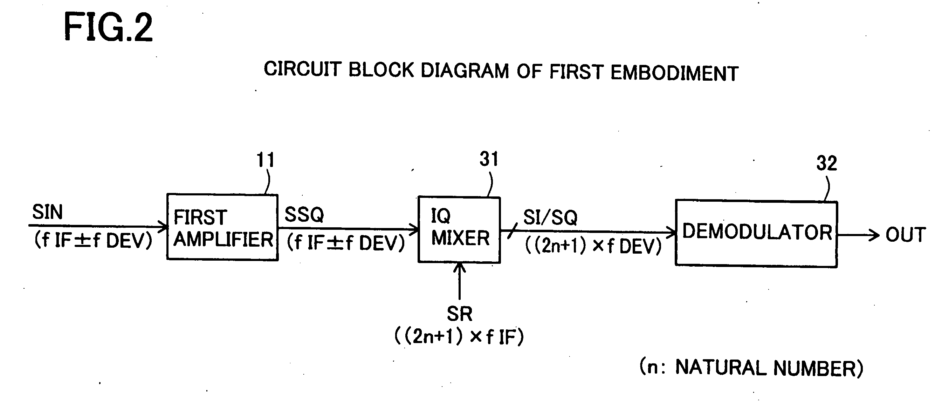

Fig. 2 shows a first embodiment. Input frequency SIN (frequency: fIF±DEV) modulated in frequency at frequency deviation (±fDEV) is put into a first amplifier 11 which is an example of signal converting unit 1. The first amplifier 11 is a circuit for amplifying an input signal SIN of small amplitude and outputting as input square signal SSQ as output signal of constant amplitude. The input signal SIN of sinusoidal wave is amplified, and the voltage level of output signal is limited at predetermined voltage level, and hence a square wave is outputted. The amplified waveform can be limited, for example, depending on limitation of output voltage range or voltage clamp by the circuit configuration of the first amplifier 11. By setting the amplified sinusoidal wave to a predetermined voltage level, a waveform containing harmonic component having the same frequency (fIF±fDEV) as the input signal SIN as fundamental frequency can be obtained. The carrier frequency (fIF) is an intermediate frequency lowered in the frequency band from the carrier frequency of high frequency used in radio communication.

Input square signal SSQ is inputted into an IQ mixer 31 which is an example for realizing the quadrature conversion in the demodulating unit 3, together with first signal SR. The frequency of the first signal SR is frequency: (2n+1) x fIF (n being a natural number). That is, it is a signal having a same frequency as 3-degree or higher odd-number harmonic about carrier frequency (fIF). The IQ mixer 31 outputs two signals SI and SQ being converted by quadrature and having a mutual phase difference of 90 degrees. The phase relation of the signals SI and SQ is inverted and outputted depending on whether the frequency deviation of the carrier frequency (fIF) is deviation to higher frequency side (frequency: fIF+fDEV) or deviation to lower frequency side (frequency: fIF-fDEV), and the signal frequency is a frequency of odd-number times of the frequency deviation (frequency: 2n+1) × fIF).

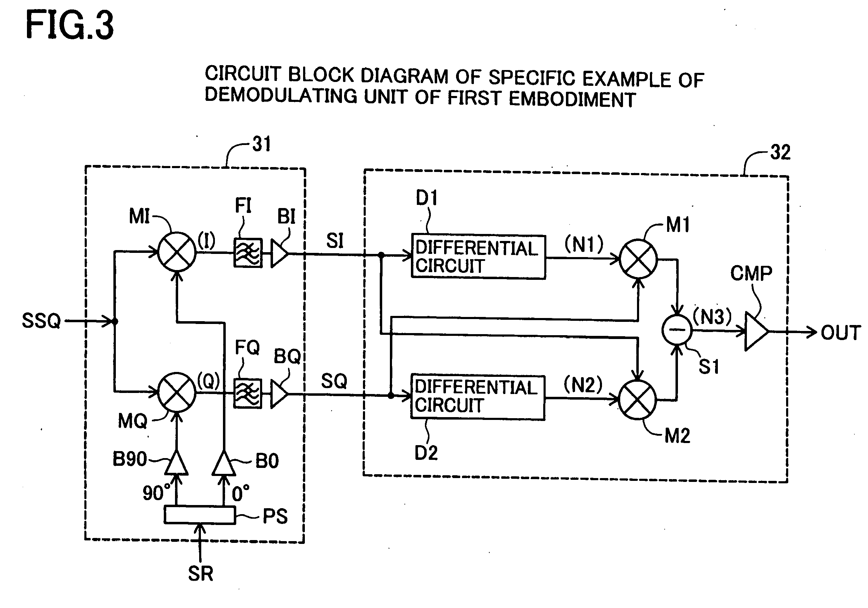

The signals SI and SQ converted by quadrature and outputted at frequency ((2n+1) × fIF) of odd-number times of frequency deviation are inputted into a demodulator 32. In the first embodiment, the IQ mixer 31 and demodulator 32 are composed as an example of demodulating unit 3. A specific structure of demodulator 32 is shown in Fig. 3.

The IQ mixer 31 has two mixer circuits MI, MQ, and input square signal SSQ is inputted in each input terminal. Also having a phase shifting circuit PS, in-phase signal (0 degree) and phase shift signal (90 degrees) are outputted to the first signal SR. The in-phase signal (0 degree) and phase shift signal (90 degrees) are inputted in other input terminal of mixer circuits MI, MQ by way of buffer circuits B0, B90. Output terminals (I), (Q) of the mixer circuits MI, MQ output input square signal SSQ, and first signal SR having a mutual phase difference of 90 degrees after mixing process. Further, by way of low pass filters FI, FQ and buffer circuits BI, BQ, signals SI, SQ having mutual phase difference of 90 degrees are outputted. In this case, in the mixer circuits MI, MQ, from the input square signal SSQ including multiple harmonic components, signals of frequency components coinciding with the frequency of the first signal SR are mixed and processed. When the frequency of the first signal SR is adjusted to the frequency coinciding with the N-degree higher harmonic of the carrier frequency of the input square signal SSQ, it is mixed with the N-degree higher harmonic of input square signal SSQ. As a result, the signals SI, SQ are outputted as signals having frequency of N times of the frequency deviation (±fDEV).

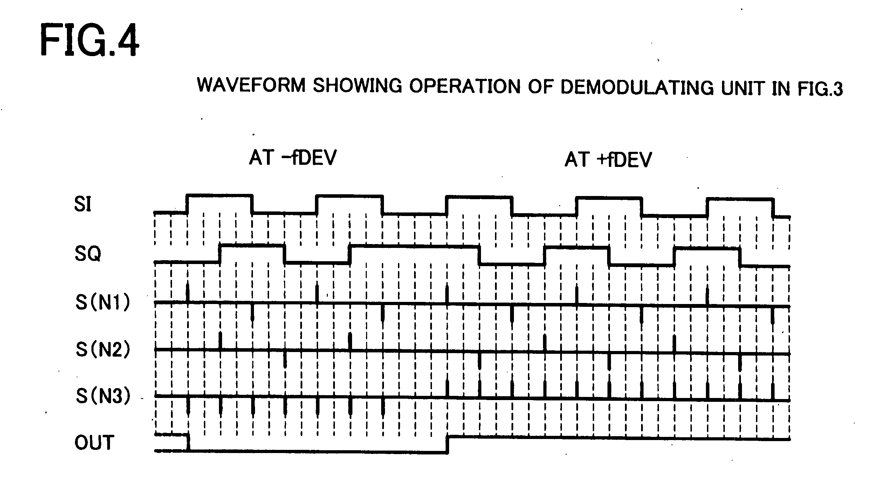

The signals SI, SQ are signals having a mutual phase difference of 90 degrees. For example, as shown in Fig. 4, when the frequency deviation is expressed as frequency: -fDEV, and the frequency is modulated to the lower frequency side of the carrier frequency, as compared with signal SQ, signal SI is outputted at an advanced phase of 90 degrees. To the contrary, when the frequency deviation is expressed as frequency: +fDEV, and the frequency is modulated to the higher frequency side of the carrier frequency, as compared with signal SQ, signal SI is outputted at a delayed phase of 90 degrees.

The signals SI, SQ having a mutual phase difference of 90 degrees are put into a demodulator 32. The demodulator 32 has two mixer circuits M1, M2. Signals SI, SQ are inputted in each input terminal of the mixer circuits M1, M2 by way of differential circuits D1, D2. Output node (N1) of differential circuit D1 is connected to one input terminal of mixer M1, and output node (N2) of differential circuit D2 is connected to one input terminal of mixer M2.

At other input terminals of the mixer circuits M1, M2, signals SQ, SI are directly inputted. That is, signal SQ is inputted in other input terminal of mixer circuit M1 and signal SI is inputted in other input terminal of mixer M2. Output signals of the mixer circuits M1, M2 are subtracted in a subtracting circuit S1, and the result of subtraction is outputted from node (N3), and a demodulated signal OUT as logic signal is modulated by way of a comparator CMP. Other input terminals of the mixer circuits M1, M2 are mixed in mutually reverse phase relation.

An operation waveform is shown in Fig. 4. In the first half of Fig. 4 corresponding to the low level period of modulated signal OUT, the frequency is modulated to the lower frequency side of the carrier frequency, and the frequency deviation is frequency: -fDEV. Having a phase advance of 90 degrees from signal SQ, signal SI is outputted. At nodes (N1), (N2), differential pulses corresponding to the level transition of signals SI, SQ are outputted (signals: S (N1), S (N2)).

Since the signal SI is advanced in phase, the mixer circuit M1 operates to mix by combining positive differential pulse signal S (N1) and negative signal SQ, and negative differential pulse signal S (N1) and positive signal SQ. By negative signal SQ, that is, reverse phase signal, the differential pulse signal S (N1) is inverted, and by positive signal SQ, that is, normal phase signal, the differential pulse signal S (N1) is directly outputted, so that a negative pulse signal is outputted as signal S (N3).

The mixer circuit M2 operates to mix by combining positive differential pulse signal S (N2) and positive signal SI, and negative differential pulse signal S (N2) and negative signal SI. Herein, in the mixer circuit M2, since the polarity of mixer operation is inverted from the mixer circuit M1, by positive signal SI, that is, normal phase signal, the differential pulse signal S (N2) is inverted and outputted, and by negative signal SI, that is, reverse phase signal, the differential pulse signal S (N2) is directly outputted. As a result, a negative pulse signal is outputted as signal S (N3).

Therefore, in the period of the frequency deviation being frequency: -fDEV, at every level transition of signals SI, SQ, a negative pulse signal is outputted to signal S (N3), and modulated signal OUT of low level is outputted depending on the comparator CMP.

In the second half of Fig. 4 corresponding to the high level period of modulated signal OUT, the frequency is modulated to the higher frequency side of the carrier frequency, and the frequency deviation is frequency: +fDEV. As compared with the first half, the phase relation of signals SI, SQ is inverted, and signal SQ is outputted at a phase advance of 90 degrees as compared with signal SI.

Since the signal SQ is advanced in phase, the mixer circuit M1 operates to mix by combining positive differential pulse signal S (N1) and positive signal SQ, and negative differential pulse signal S (N1) and negative signal SQ. By positive signal SQ, that is, normal phase signal, the differential pulse signal S (N1) is outputted directly, and by negative signal SQ, that is, reverse phase signal, the differential pulse signal S (N1) is inverted and outputted. As a result, a positive pulse signal is outputted as signal S (N3).

The mixer circuit M2 operates to mix by combining positive differential pulse signal S (N2) and negative signal SI, and negative differential pulse signal S (N2) and positive signal SI. Herein, in the mixer circuit M2, since the polarity of mixer operation is inverted from the mixer circuit M1, by negative signal SI, that is, reverse phase signal, the differential pulse signal S (N2) is directly outputted, and by positive signal SI, that is, normal phase signal, the differential pulse signal S (N2) is inverted and outputted. As a result, a positive pulse signal is outputted as signal S (N3).

Therefore, in the period of the frequency deviation being frequency: +fDEV, at every level transition of signals SI, SQ, a positive pulse signal is outputted to signal S (N3), and modulated signal OUT of high level is outputted depending on the comparator CMP.

As clear from Fig. 4, modulated signal OUT is detected in every phase of 90 degrees in signals SI, SQ. That is, the data value transmitted at time interval of 1/4 of period of signals SI, SQ is detected.

According to the first embodiment, signals SI, SQ are signals having odd-number times of frequency ((2n+1) x fDEV) of frequency deviation. By contrast, the data transmission rate in the frequency modulated transmission data by FSK modulation or the like modulated to the lower/higher frequency side of the carrier frequency depending on the data value to be transmitted is a specific frequency determined separately. The frequency of data transmission rate and frequency of frequency deviation are determined independently, and data transition timing and level transition timing of signals SI, SQ are not synchronous. The data value to be transmitted is detected at 1/4 timing of period of signals SI, SQ. In other words, the timing of transition detection of transmission data varies in time width of 1/4 of period of signals SI, SQ. In the first embodiment, since the frequency of signals SI, SQ are set at an odd-number times frequency of frequency deviation, the time interval for detecting the transmission data can be narrowed, and the time deviation of detection timing can be suppressed. Hence, jitter of modulated signal OUT can be suppressed.

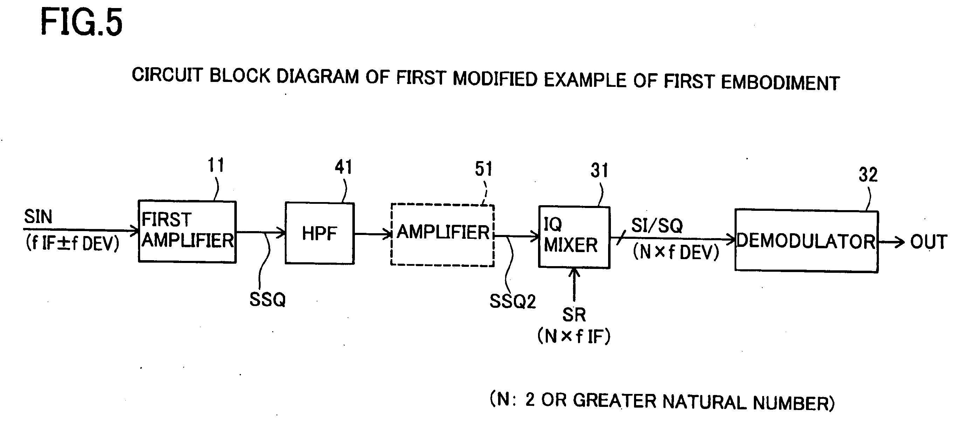

Fig. 5 shows a first modified example of the first embodiment (Fig. 2). It further comprises a high pass filter 41 between the first amplifier 11 and IQ mixer 31 in the first embodiment (Fig. 2). If the signal intensity outputted from the high pass filter 41 is insufficient, it is preferred to install an amplifier 51 in a later stage. By the high pass filter 41, input filter signal SSQ2 outputted by suppressing the low frequency component of the input square signal SSQ is put into one input terminal of the IQ mixer 31, either directly or after being amplified by the amplifier 51 if the signal intensity from the high pass filter 41 is insufficient.

Herein, the lower limit frequency of passing frequency band in the high pass filter 41 is preferred to be frequency (N x fIF) (N being 2 or greater natural number) desired to operate to mix by first signal SR. Accordingly, the signal of carrier frequency, and harmonic signal of lower frequency than the lower limit frequency are suppressed by the high pass filter 41 and eliminated from input filter signal SSQ2. Generally, the filter characteristic of the high pass filter 41 has the peak of signal intensity at the lower limit frequency, and is limited in the signal intensity as for the signal components of higher frequency than the lower limit frequency, and hence the signal intensity can be suppressed low as for the signals of harmonic components of higher frequency than the lower limit frequency. That is, input of signal components having frequency other than lower limit frequency into the IQ mixer 31 is suppressed. As a result, the IQ mixer 31 can mix more efficiently as for desired signal components of lower limit frequency.

If the signal intensity of signal components having the lower limit frequency is insufficient and the intensity difference from the signal intensity of floor noise components becomes smaller and jitter by floor noise may be superposed on the demodulated signal OUT, by installing the amplifier 51, the signal intensity can be amplified mainly at the lower limit frequency, and the jitter superposed on the demodulated signal OUT can be suppressed.

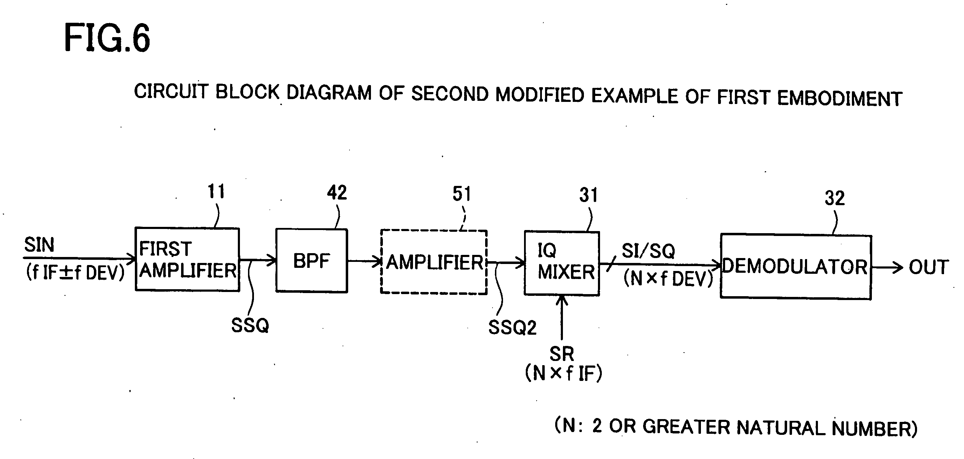

In a second modified example in Fig. 6, instead of the high pass filter 41 in the first modified example (Fig. 5), a band pass filter 42 is provided. By the high pass filter 41 for setting the lower limit frequency of the passing frequency band at the frequency desired to operate by mixing, the signal intensity can be selectively reinforced mainly at the lower limit frequency in the input filter signal SSQ2, and in the second modified example, by using the band pass filter 42 instead of the high pass filter 41, the signal at the frequency desired to operate by mixing as input filter signal SSQ2 can be selected more positively and passed. As a result, the signal intensity of signal components other than the desired frequency can be suppressed more securely. That is, input of signal components having frequency other than the desired frequency into the IQ mixer 31 is suppressed more securely. Hence, the IQ mixer 31 can mix more efficiently as for signal components of the desired frequency.

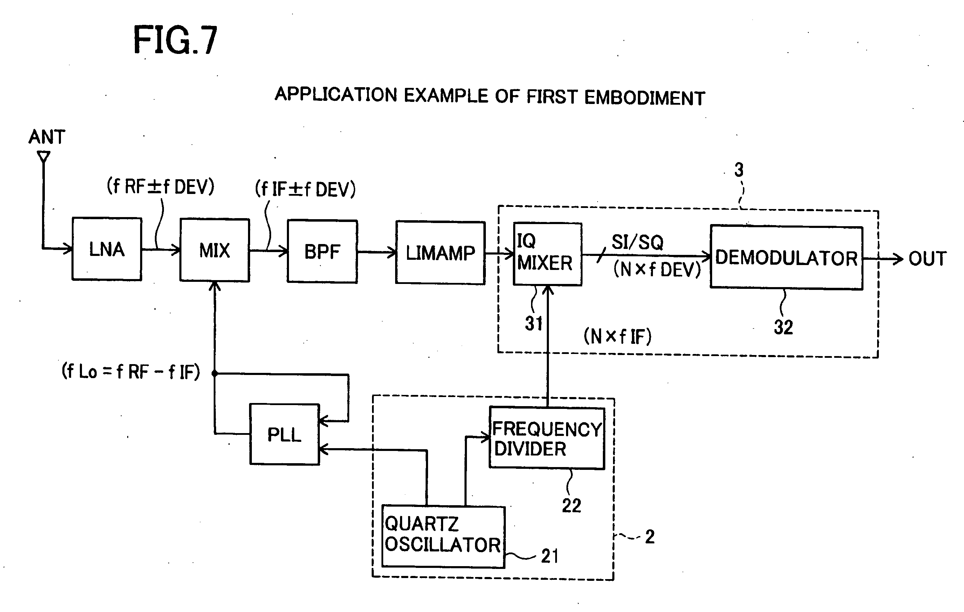

Fig. 7 shows a circuit example in which the demodulator in the first embodiment is applied in a demodulator for receiving and demodulating a frequency modulated radio communication signal such as FSK modulation. A frequency modulated signal received by an antenna ANT is amplified by a low noise amplifier LNA. The amplified signal is a frequency modulated signal at frequency deviation (±fDEV) from carrier frequency (fRF). It is put into one input terminal of mixer circuit MIX.

At other input terminal of mixer circuit MIX, a local signal locked at a predetermined frequency (fL01 = fRF-fIF) in phase locked loop circuit PLL is inputted. Reference frequency signal to the phase locked loop circuit PLL is supplied from quartz oscillator 21. In the phase locked loop circuit PLL, a signal of predetermined frequency outputted from the quartz oscillator 21 is divided, and a first local signal is outputted. Herein, the frequency (fIF) is in an intermediate frequency band lowered in the frequency band from the carrier frequency (fRF) of high frequency band. For example, as compared with high frequency (fRF = 430 MHz), the intermediate frequency (fIF) is 450 kHz.

The signal (frequency: fRF±fDEV) amplified by the low noise amplifier LNA and the local signal (frequency: fLO1 = fRF-fIF) are mixed, and the mixer circuit MIX outputs a signal in intermediate frequency band (fIF±fDEV). Hence, the signal in high frequency band (fRF±fDEV) by radio communication is limited in the frequency band to the signal in the intermediate frequency band (fIF±fDEV).

The band limited signal (fIF±fDEV) is restricted in the passing frequency by the band pass filter BPF, and the output signal is amplified by an amplifier LIMAMP for limiting the amplitude. This amplifier LIMAMP is an example of first amplifier 11, and is an amplifier for amplifying an input signal of small amplitude into an output signal of predetermined amplitude. For example, by connecting amplifiers in multiple stages, the voltage amplitude level of the output signal at the final amplifier stage can be amplified up to the upper limit of output possible range of output transistor.

The amplifier LIMAMP outputs a square shaped signal. The output square signal is a signal of large signal intensity of harmonic components of odd-number degree, based on the fundamental frequency of frequency (fIF±fDEV) of the signal limited in band by the mixer circuit MIX. This square signal is put into the decoder 3.

The decoder 3 is composed of IQ mixer 31 and decoder 32 for receiving the output signal of the IQ mixer 31. The square signal is put into one input terminal of the IQ mixer 31. At other input terminal of the IQ mixer 31, a first signal (frequency: N x fIF) (N being 2 or greater natural number) outputted from the signal output unit 2 is inputted. It is a signal having a frequency of N times of frequency: fIF of intermediate frequency band. The square signal outputted from the amplifier LIMAMP is a signal of larger signal intensity in the harmonic components of odd-number degree as compared with harmonic component of even-number degree, but the first signal may be either odd-number multiple or even-number multiple of intermediate frequency band (fIF) as far as the signal intensity is sufficient.

The signal output unit 2 is composed of quartz oscillator 21 and frequency divider 22 for dividing the reference frequency signal outputted from the quartz oscillator 21. The signal divided into frequency (N x fIF) by the frequency divider 22 is put into other input terminal of the IQ mixer circuit 31.

In the IQ mixer circuit 31, the square signal and first signal are converted by quadrature. The signals are mixed at the desired frequency of frequency (N x fIF) of first signal, and signals SI, SQ mutually inverted in phase by 90 degrees, depending on the direction of deviation, having frequency of N times (N x fDEV) of frequency deviation are outputted, and demodulated in the demodulator 32.

As described specifically above, according to the demodulator and demodulating method of frequency modulated signals of the embodiment, as shown in Fig. 2, N-degree higher harmonic is taken out from input square signal SSQ (frequency: fIF±fDEV) of same frequency as input signal SIN (frequency: fIF±fDEV), and can be demodulated by quadrature conversion. It produces two logic signals SI, SQ inverted in mutual phase difference of 90 degrees depending on the direction of frequency deviation, at N times of frequency (N x fDEV) of the frequency deviation (±fDEV). A demodulated signal OUT is obtained by logic operation of logic signal SI, SQ. In addition to excellent resistance to noise of the demodulated signal OUT, since the signal is demodulated at N times of frequency of frequency deviation (±fDEV), the deviation width of transition timing of transmission signal and demodulation timing can be suppressed, and jitter of demodulated signal OUT can be suppressed.

By demodulating at N times of frequency of frequency deviation (±fDEV) by making use of N-degree higher harmonics, even if the frequency deviation (±fDEV) is narrowed by effective utilization of frequency band, demodulated signal OUT of controlled jitter can be obtained.

The invention is not limited to the illustrated embodiment alone, but may be changed and modified freely within the scope of the invention. For example, in the embodiment, as signal output unit 2, in Fig. 7, the reference frequency signal outputted from the quartz oscillator 21 is divided by the frequency divider 22 is described, but the invention is not limited to this example alone, but a large signal SR can be supplied by using a phase locked loop circuit.

The invention presents the demodulator of frequency modulated signals and the demodulating method of frequency modulated signals capable of demodulating frequency modulated signals having frequency deviation into stable demodulated signals suppressed in jitter.

## Claims

1. A demodulator for demodulating frequency modulated input signals (SIN) having a frequency deviation from a carrier frequency **characterized by**:
a first amplifier (11) for converting the frequency modulated input signal into a square wave signal (SSQ) of same frequency of the carrier frequency; **characterized by**
a local oscillator source (PS, BO and B90) for generating an in-phase signal and a quadrature signal having a frequency coinciding with N-degree higher harmonic wave (N being 2 or a greater natural number) of the carrier frequency;
an in-phase mixer (M1) which receives the square wave signal and the in-phase signal;
a quadrature mixer (MQ) which receives the square wave signal and the quadrature signal: and
a demodulation unit (32) for demodulating the frequency modulated input signal corresponding to a mutual phase difference between signals outputted from the in-phase mixer and from the quadrature mixer which have a frequency coinciding with the N-degree higher harmonic wave

2. The demodulator of frequency modulated signals of claim 1,
wherein the square wave signal outputted from the first amplifier is inputted into the in-phase mixer and the quadrature mixer by way of a filter (41, 42).

3. The demodulator of frequency modulated signals of claim 1,
wherein a second amplifier (51) is provided in the preceding stage of the in-phase mixer and the quadrature mixer and the square wave signal outputted from the first amplifier is once amplified by the second amplifier by way of a filter (41. 42), and then put into the in-phase mixer and the quadrature mixer.

4. The demodulator of frequency modulated signals of claim 2,
wherein the filter is a high pass filter (41).

5. The demodulator of frequency modulated signals of claim 3,
wherein the filter is a high pass filter (41).

6. The demodulator of frequency modulated signals of claim 2, wherein the filter is a band pass filter (42).

7. The demodulator of frequency modulated signals of claim 3, wherein the filter is a band pass filter (42).

8. The demodulator of frequency modulated signals of claim 1, wherein the local oscillator source includes a primary oscillator (21), and a frequency divider (22) for dividing a primary oscillation signal of the primary oscillator, and the frequency of the first signal is adjusted depending on the frequency of the primary oscillation signal and a dividing ratio of the frequency divider.

9. A demodulating method for demodulating frequency modulated input signals (SIN) having a frequency deviation from a carrier frequency comprising:
a step of converting (11) the input signal into a square wave signal of same frequency; and
a step of demodulating (31. 32) by converting the square wave signal by quadrature, depending on a first signal of frequency coinciding with N-degree higher harmonic wave (N being 2 or a greater natural number) of the carrier frequency.

10. The demodulating method of frequency modulated signals of claim 9, wherein the step of demodulating is preceded by a step of extracting (31) a predetermined harmonic component including the N-degree higher harmonic wave from the square wave signal.

11. The demodulating method of frequency modulated signals of claim 10, wherein the predetermined harmonic component is a harmonic component in intermediate frequency band including the N-degree higher harmonic wave.

12. The demodulating method of frequency modulated signals of claim 10, wherein the predetermined harmonic component is a harmonic component in a high frequency band based on the N-degree higher harmonic wave as the lower limit frequency.

## Patentansprüche

1. Demodulator, zum Demodulieren von frequenzmodulierten Eingangssignalen (SIN), die eine Frequenzabweichung von einer Trägerfrequenz aufweisen, **gekennzeichnet durch**:
einen ersten Verstärker (11) zum Konvertieren des frequenzmodulierten Eingangssignals in ein Rechtecksignal (SSQ) mit derselben Frequenz wie die Trägerfrequenz; **gekennzeichnet durch**
eine Lokaloszillatorquelle (PS, B0 und B90) zum Erzeugen eines In-Phase-Signals und eines Quadratur-Signals mit einer Frequenz, die mit einer höheren Harmonischen N-ten Grades (wobei N gleich 2 oder eine größere natürliche Zahl ist) der Trägerfrequenz koinzidiert;
einen In-Phase-Mischer (MI), der das Rechtecksignal und das In-Phase-Signal empfängt;
einen Quadratur-Mischer (MQ), der das Rechtecksignal und das Quadratur-Signal empfängt; und
eine Demodulationseinheit (32) zum Demodulieren des frequenzmodulierten Eingangssignals entsprechend einer gegenseitigen Phasendifferenz zwischen Signalen, die von dem In-Phase-Mischer und von dem Quadratur-Mischer ausgegeben werden, die eine Frequenz haben, die mit der höheren Harmonischen N-ten Grades koinzidiert.

2. Demodulator für frequenzmodulierte Signale nach Anspruch 1,
bei dem das Rechtecksignal, das von dem ersten Verstärker ausgegeben wird, dem In-Phase-Mischer und dem Quadratur-Mischer über ein Filter (41, 42) eingegeben wird.

3. Demodulator für frequenzmodulierte Signale nach Anspruch 1,
bei dem ein zweiter Verstärker (51) in der dem In-Phase-Mischer und dem Quadratur-Mischer vorhergehenden Stufe vorgesehen ist und das Rechtecksignal, das von dem ersten Verstärker ausgegeben wird, über ein Filter (41, 42) erst durch den zweiten Verstärker verstärkt wird und dann dem In-Phase-Mischer und dem Quadratur-Mischer eingegeben wird.

4. Demodulator für frequenzmodulierte Signale nach Anspruch 2,
bei dem das Filter ein Hochpassfilter (41) ist.

5. Demodulator für frequenzmodulierte Signale nach Anspruch 3,
bei dem das Filter ein Hochpassfilter (41) ist.

6. Demodulator für frequenzmodulierte Signale nach Anspruch 2,
bei dem das Filter ein Bandpassfilter (42) ist.

7. Demodulator für frequenzmodulierte Signale nach Anspruch 3,
bei dem das Filter ein Bandpassfilter (42) ist.

8. Demodulator für frequenzmodulierte Signale nach Anspruch 1,
bei dem die Lokaloszillatorquelle einen Primäroszillator (21) und einen Frequenzteiler (22) zum Teilen eines Primäroszillationssignals des Primäroszillators enthält und die Frequenz des ersten Signals in Abhängigkeit von der Frequenz des Primäroszillationssignals und einem Teilungsverhältnis des Frequenzteilers eingestellt wird.

9. Demodulationsverfahren, zum Demodulieren von frequenzmodulierten Eingangssignalen (SIN), die eine Frequenzabweichung von einer Trägerfrequenz aufweisen, mit:
einem Schritt zum Konvertieren (11) des Eingangssignals in ein Rechtecksignal mit ebendieser Frequenz; und
einem Schritt zum Demodulieren (31, 32) durch Quadraturkonvertierung des Rechtecksignals, in Abhängigkeit von einem ersten Signal, das eine Frequenz hat, die mit einer höheren Harmonischen N-ten Grades (wobei N gleich 2 oder eine größere natürliche Zahl ist) der Trägerfrequenz koinzidiert.

10. Demodulationsverfahren für frequenzmodulierte Signale nach Anspruch 9,
wobei dem Schritt zum Demodulieren ein Schritt vorausgeht zum Extrahieren (31) einer vorbestimmten harmonischen Komponente, welche die höhere Harmonische N-ten Grades enthält, aus dem Rechtecksignal.

11. Demodulationsverfahren für frequenzmodulierte Signale nach Anspruch 10,
bei dem die vorbestimmte harmonische Komponente eine harmonische Komponente im Zwischenfrequenzband ist, welche die höhere Harmonische N-ten Grades enthält.

12. Demodulationsverfahren für frequenzmodulierte Signale nach Anspruch 10,
bei dem die vorbestimmte harmonische Komponente eine harmonische Komponente in einem Hochfrequenzband ist, die auf der höheren Harmonischen N-ten Grades als untere Grenzfrequenz basiert.

## Revendications

1. Démodulateur pour démoduler des signaux d'entrée (SIN) modulés en fréquence ayant un écart de fréquence par rapport à une fréquence de porteuse, **caractérisé par** :
un premier amplificateur (11) pour convertir le signal d'entrée modulé en fréquence en un signal d'onde carrée (SSQ) dont la fréquence est identique à la fréquence de porteuse ;
**caractérisé par** :
une source d'oscillation locale (PS, BO et B90) pour générer un signal en phase et un signal en quadrature ayant une fréquence coïncidant avec une onde harmonique d'ordre supérieur N (N étant égal à 2 ou un nombre naturel plus grand) de la fréquence de porteuse ;
un mélangeur en phase (M1) qui reçoit le signal d'onde carrée et le signal en phase ;
un mélangeur en quadrature (MQ) qui reçoit le signal d'onde carrée et le signal en quadrature ; et
une unité de démodulation (32) pour démoduler le signal d'entrée modulé en fréquence correspondant à une différence de phase mutuelle entre des signaux délivrés par le mélangeur en phase et par le mélangeur en quadrature qui ont une fréquence coïncidant avec l'onde harmonique d'ordre supérieur N.

2. Démodulateur de signaux modulés en fréquence selon la revendication 1,
dans lequel le signal d'onde carrée délivré par le premier amplificateur est appliqué au mélangeur en phase et au mélangeur en quadrature au moyen d'un filtre (41, 42).

3. Démodulateur de signaux modulés en fréquence selon la revendication 1,
dans lequel un deuxième amplificateur (51) est prévu dans l'étape précédente du mélangeur en phase et du mélangeur en quadrature et le signal d'onde carrée délivré par le premier amplificateur est d'abord amplifié par le deuxième amplificateur au moyen d'un filtre (41, 42) et ensuite appliqué au mélangeur en phase et au mélangeur en quadrature.

4. Démodulateur de signaux modulés en fréquence selon la revendication 2,
dans lequel le filtre est un filtre passe-haut (41).

5. Démodulateur de signaux modulés en fréquence selon la revendication 3,
dans lequel le filtre est un filtre passe-haut (41).

6. Démodulateur de signaux modulés en fréquence selon la revendication 2, dans lequel le filtre est un filtre passe bande (42).

7. Démodulateur de signaux modulés en fréquence selon la revendication 3, dans lequel le filtre est un filtre passe bande (42).

8. Démodulateur de signaux modulés en fréquence selon la revendication 1, dans lequel la source d'oscillation locale comprend un oscillateur principal (21) et un diviseur de fréquence (22) pour diviser un signal d'oscillation principal de l'oscillateur principal, et la fréquence du premier signal est ajustée en fonction de la fréquence du signal d'oscillation principal et d'un rapport de division du diviseur de fréquence.

9. Procédé de démodulation pour démoduler des signaux d'entrée (SIN) modulés en fréquence ayant un écart de fréquence par rapport à une fréquence de porteuse comprenant :
une étape de conversion (11) du signal d'entrée en un signal d'onde carrée de même fréquence ; et
une étape de démodulation (31, 32) par la conversion du signal d'onde carrée par quadrature, en fonction d'un premier signal d'une fréquence coïncidant avec une onde harmonique d'ordre supérieur N (N étant égal à 2 ou un nombre naturel plus grand) de la fréquence de porteuse.

10. Procédé de démodulation de signaux modulés en fréquence selon la revendication 9, dans lequel l'étape de démodulation est précédée d'une étape d'extraction (31) d'une composante harmonique prédéterminée comprenant l'onde harmonique d'ordre supérieur N du signal d'onde carrée.

11. Procédé de démodulation de signaux modulés en fréquence selon la revendication 10, dans lequel la composante harmonique prédéterminée est une composante harmonique dans une bande de fréquence intermédiaire comprenant l'onde harmonique d'ordre supérieur N.

12. Procédé de démodulation de signaux modulés en fréquence selon la revendication 10, dans lequel la composante harmonique prédéterminée est une composante harmonique dans une bande de fréquence élevée basée sur l'onde harmonique d'ordre supérieur N en tant que fréquence de limite inférieure.
